# EUROPEAN PATENT APPLICATION

(11) **EP 2 154 714 A2**
(43) Date of publication of application: **17.02.2010**
(21) Application number: 09009135.6
(22) Date of filing: 14.07.2009
(51) Int. Cl.: H01L 21/56, G01D 11/24, G01K 7/01, G01N 27/22

(54) **Temperature sensor with buffer layer**

(30) Priority: 11.08.2008 EP 08014276
(71) Applicant: Sensirion AG, 8712 Stäfa (CH)
(72) Inventor: Hunziker, Werner, 8712 Stäfa (CH); Brem, Franziska, 8008 Zürich (CH); Hummel, René, CH-6340 Baar (CH); Graf, Markus, 8005 Zürich (CH)
(74) Representative: Sutter, Kurt

(57) **Abstract**

A temperature sensor with a bandgap circuit (3) is provided. The bandgap circuit (3) is covered by a buffer layer (6) of photoresist. The device is packaged in a housing (16). By providing the buffer layer (6), mechanical stress in the bandgap circuit, as it is e.g. caused by different thermal expansion coefficients of the packaging and the chip, can be reduced. This improves the accuracy of the device.

## Description

### CROSS REFERENCE TO RELATED APPLICATIONS

This application claims the priority of European patent application 08014276.3, filed August 11, 2008, the disclosure of which is incorporated herein by reference in its entirety.

### BACKGROUND OF THE INVENTION

The invention relates to a temperature sensor and a method for manufacturing the same. In particular it relates to a temperature sensor comprising a semiconductor chip, a bandgap circuit integrated on a first surface of said chip, and a housing for embedding the chip.

It has been known to provide temperature sensors based on semiconductor chips with bandgap circuits integrated thereon. Such temperature sensors are typically covered by a housing. It has been found that such sensors can be subject to drift and inaccuracies.

### BRIEF SUMMARY OF THE INVENTION

It is an object of the present invention to provide a temperature sensor and a method for its manufacture that provides improved accuracy.

This object is achieved by the sensor and method of the independent claims. Accordingly, a buffer layer of a polymer is applied to the semiconductor chip and covers the bandgap circuit. Hence, the buffer layer is arranged between the bandgap circuit and the material of the housing. This arrangement prevents mechanical strain from being transferred between housing and bandgap circuit. Since the voltage of the bandgap circuit depends not only on temperature, but also on mechanical stress, the buffer layer improves the accuracy of the device.

Advantageously, the buffer layer is made of a photoresist. This is a material that can be structured using photolithography, or the product of such a material after structuring by means of photolithography. For example, the buffer layer can comprise an epoxy-based photoresist, in particular SU-8.

The temperature sensor can further comprise an integrated sensitive structure, such as a polymer film for measuring humidity, in which case the housing can be provided with an access opening extending to the integrated sensitive structure. Thus, the temperature sensor can further measure humidity or some other parameter of the environment.

Alternatively, the housing can cover the whole of the first surface of the chip, i.e. of the surface on which the bandgap circuit has been integrated.

### BRIEF DESCRIPTION OF THE DRAWINGS

Other advantageous embodiments are described in the dependent claims as well as in the following description, wherein the description refers to the attached figures. These show:
Fig. 1 a first step in a manufacturing process of a first embodiment of the sensor, prior to applying the buffer layer,
Fig. 2 a second step, after applying the buffer layer,
Fig. 3 a third step, after structuring the buffer layer,
Fig. 4 a fourth step, after cutting the wafer and applying the chip to the lead frame,
Fig. 5 a fifth step prior to casting,
Fig. 6 a sixth step, after removing the mold,
Fig. 7 a reference voltage generator and temperature sensor, and
Fig. 8 is a second embodiment of a sensor.

### DETAILED DESCRIPTION OF THE INVENTION

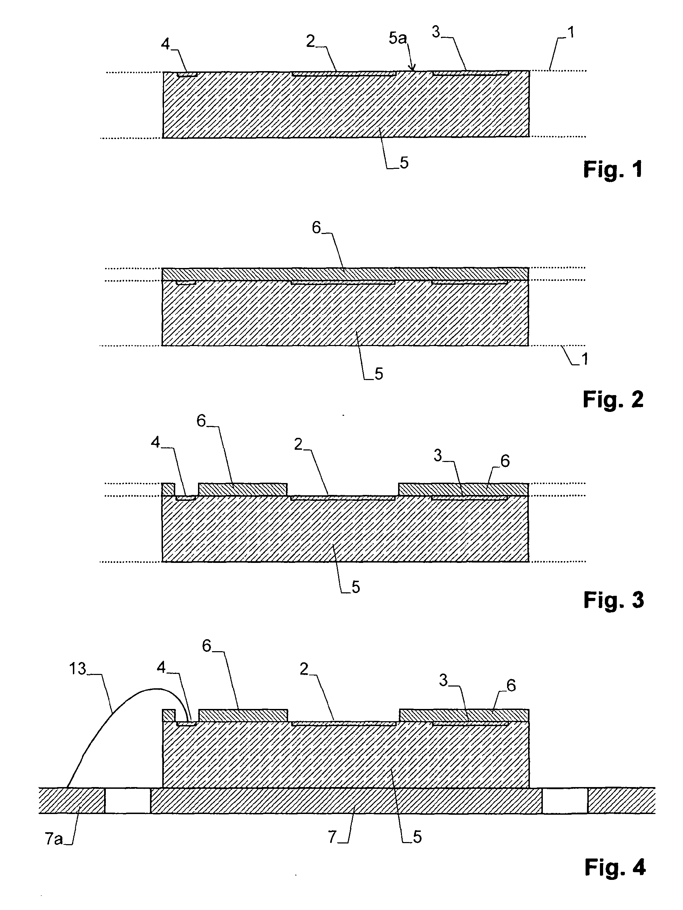

In the following, a first embodiment of the manufacturing process and sensor according to the invention is described by reference to Figs. 1 to 6. This embodiment relates to a sensor that is a temperature sensor as well as a humidity sensor.

In a first step, a plurality of sensor chips is manufactured simultaneously on a wafer 1. Fig. 1 shows a single chip 5 in detail. Each chip may e.g. be a humidity sensor as it is described in US 6 690 569 with a band gap temperature sensor 3 integrated on a first surface 5a thereof. Or it may be any other type of sensor having a sensitive structure 2 and a band gap circuit 3 integrated on its first surface 5a. Sensitive structure 2 may e.g. be the polymer film of a humidity sensor with underlying electrodes as described in US 6 690 569. In addition to a band gap temperature sensor 3, further circuitry may be integrated on chip 5, such as analog amplifiers, analog-digital converts and digital processing electronics.

Furthermore, bond pads 4 are provided on first surface 5a for connecting the band gap circuit and any other circuitry to bond wires.

In a next step, a buffer layer 6 is applied over wafer 1. Buffer layer 6 is advantageously a photoresist, such as SU-8 by MicroChem Corp., USA. Using a photoresist layer as buffer layer 6 has the advantage that it can be structured easily using standardized processing steps.

If buffer layer 6 is a photoresist, it can be structured directly by means of photolithography in order to remove it at least partially at the location of sensitive structure 2 as well as at the location of the bond pads 4, as shown in Fig. 3, while leaving it to cover at least band gap circuit 3.

Thus, buffer layer 6 is removed to uncover the contact pads 4 and at least part of sensitive structure 2. In other words, buffer layer 6 does not cover the contact pads 4 such that the contact pads 4 can later be contacted by the bond wires. Neither does buffer layer 6 extend over all of sensitive structure 2, but surrounds it, such that said structure can later be exposed to the environment. All steps up to this point can be carried out prior to cutting wafer 1.

Now, wafer 1 is cut into the chips 5, and a plurality of the chips 5 are placed on a lead frame 7 in known manner, as shown in Fig. 4. The chips 5 may e.g. be glued to the lead frame 7. Bond wires 13 are mounted between the contact pads 4 and the leads 7a of lead frame 7.

In a next step, lead frame 7 is placed in a mold comprising a lid 8 and a base 9. The mold defines an interior space 10 to be filled by a hardening material. Lid 8 has a section 11 that extends into interior space 10. Section 11 is located and dimensioned such that, when the mold is closed, it abuts against buffer layer 6 along a circumference of sensitive structure 2, thereby forming a sealed cavity 12 over sensitive structure 2.

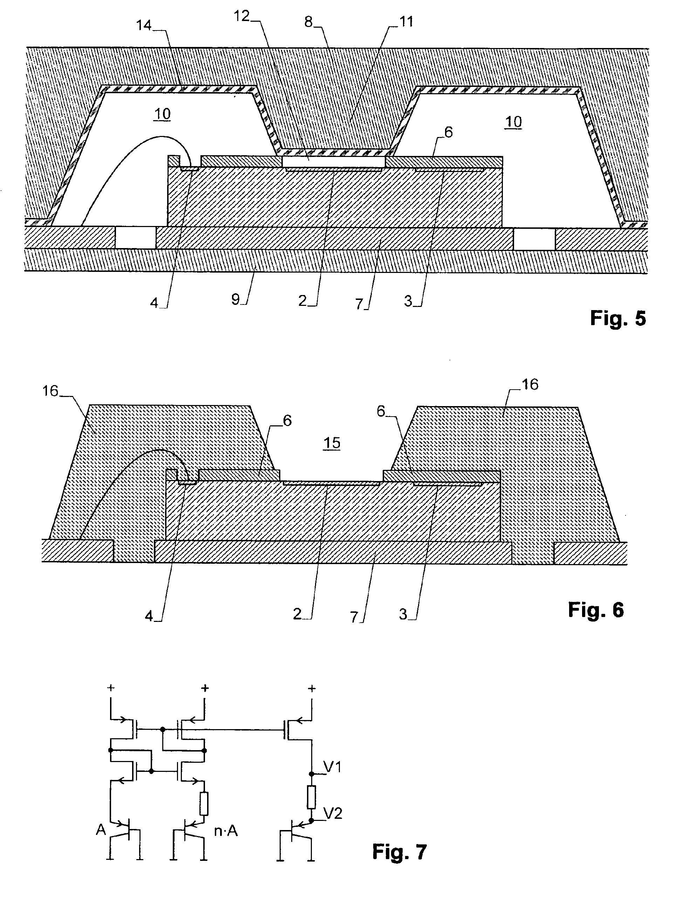

As shown in Fig. 5, a foil assisted molding process can be used. In such a process, a film 14 is placed over at least one of the parts of mold 8, 9 on the side facing interior space 10. Film 14 may e.g. be a ETFE film having a thickness between 50 and 100 µm. A suitable example of such a film is Nowoflon ET6235J by Nowofol, Siegsdorf (Germany) or Fluon by Asahi Glass Co., Japan. Such a foil compensates mechanical tolerances, reduces the wear of the mold and simplifies the removal of the mold after the casting process. Similarly, base 9 can be covered by a polyester foil. A suitable polyester foil is e.g. RM4100 by Hitachi Chemicals, Japan.

In a next step, a hardening material is introduced into the mold to fill interior space 10.

After hardening the material at least partially in order to form a package or housing 16 that covers and/or surrounds chip 5, mold 8, 9 is removed, thereby forming the substantially completed device as shown in Fig. 6. As can be seen, section 11 has formed an access opening 15 that connects sensitive structure 2 with the surroundings of the device.

According to the present invention, buffer layer 6 is formed such that it covers bandgap circuit 3 in order to protect it from mechanical stress, such as strain.

For providing a good mechanical protection during molding and thereafter, and in order to avoid a damage of sensitive structure 2 during the molding process, buffer layer 6 advantageously has the following properties:
- Its height should be sufficient such that film 14 is prevented from touching sensitive structure 2 during the molding process. Advantageously, the height of buffer layer 6 is at least 10 µm.
- It should be sufficiently elastic in order to form a good seal during the molding process and in order to be able to accommodate for mutual movements between housing 16 and the circuitry semiconductor chip 5. In particular, and even for embodiments that do not comprise a sensitive structure 2, such as the second embodiment described below, it should be more elastic than normal cover layers applied over semiconductor chips, in particular SiN and SiO₂. In particular, buffer layer 6 should have a Young's module of less than 10 GPa, which is clearly smaller than the Young's modules of SiN (> 150 GPa) and SiO₂ (> 70 GPa).

While, as described above, buffer layer 6 is advantageously a photoresist, it can also be any other polymer, such as a resin system, e.g. epoxy, in particular a photostructurable resin system such that it can be structured easily. Resin systems have been found to be compatible with the materials that are usually used for injection-molded semiconductor device packaging.

Alternatively, buffer layer 6 may e.g. also be or comprise a rubber, e.g. silicone rubber, or polyimide. If it is not a photoresist, a separate photoresist layer can e.g. be placed on top of it, which then can be structured to form a mask for subsequently etching the buffer layer at the desired locations.

Alternatively, buffer layer 6 may also be applied using printing techniques, such as stencil printing or screen printing, in particular if buffer layer 6 is a silicone rubber.

As mentioned, buffer layer 6 not only serves to provide a seal with section 11 in the molding process, but it also protects the bandgap circuit 3 from strain. Hence, it is structured such that it covers substantially all of bandgap circuit 3.

This is based on the understanding that mechanical stress strongly affects the properties of semiconductor electronic components, while, at the same time, buffer layer 6 can be used not only as a contact surface for section 11 of the mold, but also as a stress relief layer.

Fig. 7 shows an embodiment of bandgap circuit 3. A constant reference voltage can be obtained at output V1, while the voltage difference between outputs V1 and V2 is a measure of the temperature.

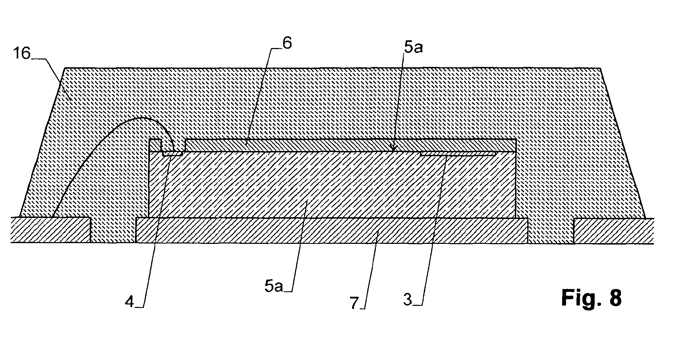

The present invention can also be carried out on temperature sensors without a sensitive structure 2, i.e. on sensors that measure temperature alone. The second embodiment shown in Fig. 8 is such a temperature sensor. It differs from the one of Fig. 6 in that all of the first surface 5a of chip 5 is covered by housing 16 and there is no access opening provided therein.

In this embodiment, buffer layer 6 covers substantially all of first surface 5a with the exception of the contact pads 4. At least, it should cover substantially all of bandgap circuit 3.

The method for manufacturing the second embodiment of Fig. 8 is substantially the same as for manufacturing the first embodiment of Fig. 6, with the exception that lid 8 has no section 11 extending into interior space 10.

Hence, in summary, a temperature sensor with a bandgap circuit 3 is provided. Bandgap circuit 3 is covered by a buffer layer 6 of e.g. photoresist. Buffer layer 6 is structured and semiconductor chip 5 is packaged in or at least covered by a housing 16. By providing the buffer layer 6, mechanical stress, as it is e.g. caused by different thermal expansion coefficients of the packaging and the chip, can be reduced.

The temperature sensor can be an all-solid, monolithic device. In particular, it advantageously does not comprise a MEMS (a micro electromechanical system), including an IMEMS (an integrated MEMS), as e.g. described in US 6 379 988.

While there are shown and described presently preferred embodiments of the invention, it is to be distinctly understood that the invention is not limited thereto but may be otherwise variously embodied and practised within the scope of the following claims.

## Claims

1. A temperature sensor comprising
a semiconductor chip (5),
a bandgap circuit (3) integrated on a first surface (5a) of said semiconductor chip (5), and
a housing (16), with said semiconductor chip (5) being covered by said housing (16),
**characterized in that** said temperature sensor further comprises a polymer buffer layer (6) applied to said semiconductor chip (5) and covering said bandgap circuit (3).

2. The temperature sensor of claim 1 wherein said buffer layer is a photoresist.

3. The temperature sensor of claim 2 wherein said buffer layer (6) comprises an epoxy-based photoresist.

4. The temperature sensor of claim 3 wherein said buffer layer (6) comprises SU-8.

5. The temperature sensor of any of the preceding claims wherein said semiconductor chip (5) comprises contact pads (4) wherein said buffer layer (6) does not cover said contact pads (4).

6. The temperature sensor of any of the preceding claims further comprising an integrated sensitive structure (2) and wherein said housing (16) comprises an access opening (15) extending to said integrated sensitive structure (2).

7. The temperature sensor of claim 6 wherein said integrated sensitive structure is a polymer film for measuring humidity.

8. The temperature sensor of any of the claims 6 or 7 wherein said buffer layer (6) does not extend over all of said integrated sensitive structure (2).

9. The temperature sensor of any of the claims 2 to 5 wherein said housing (16) covers the whole of said first surface (5a) of said chip (5).

10. The temperature sensor of any of the preceding claims not comprising a MEMS device.

11. A method for manufacturing a temperature sensor comprising a semiconductor chip (5) with a band gap circuit integrated thereon, said method comprising the steps of
applying, onto a first surface (5a) of said chip (5), a photoresist buffer layer (6),
lithographically structuring said buffer layer (6) in order to remove part of said buffer layer but leaving said buffer layer covering said bandgap circuit (3),
casting a housing (16) over said chip (5), with said housing (16) covering said buffer layer (6).

12. The method of claim 11 wherein said chip further comprises an integrated sensitive structure (2), and wherein said method further comprises the steps of
structuring said buffer layer (6) such that at least part of said sensitive structure (2) is uncovered,
providing a mold (8, 9) defining an interior space (10) and having a section (11) extending into said interior space (10),
placing said chip (5) in said mold (8, 9) with said section (11) abutting against said buffer layer (6),
introducing a hardening material into said mold (8, 9) for casting said housing (16) over said chip,
after hardening said material at least partially, removing said section (11) thereby forming an access opening (15) extending to said sensitive structure (2).

13. The method of any of the claims 10 or 12 comprising the steps of
manufacturing a plurality of said chips (5) together on a single wafer (1),
applying said buffer layer (6) to said wafer,
lithographically structuring said buffer layer (6) and, thereafter,
cutting said wafer (1) into said chips (5).
